Europäisches Patentamt

European Patent Office

Office européen des brevets

(19)

(11) Numéro de publication: **0 343 584**

**A1**

(12) **DEMANDE DE BREVET EUROPEEN**

(21) Numéro de dépôt: 89109231.4

(22) Date de dépôt: 23.05.89

(51) Int. Cl.⁴: **H04N 1/415 , H03M 7/48**

(30) Priorité: 26.05.88 FR 8807013

(43) Date de publication de la demande:
29.11.89 Bulletin 89/48

(84) Etats contractants désignés:
AT BE CH DE ES FR GB GR IT LI LU NL SE

(71) Demandeur: **TELIC ALCATEL**
**12, rue de la Baume**
**F-75008 Paris(FR)**

(72) Inventeur: **De Baudus, Bruno**
**40 rue Pierre Arnoux**
**F-92190 Meudon(FR)**

(74) Mandataire: **Weinmiller, Jürgen et al**
**Lennéstrasse 9 Postfach 24**
**D-8133 Feldafing(DE)**

(54) **Procédé de transcodage de données numériques d'image "bitmap".**

(57) Le procédé de transcodage assure la conversion de signaux numériques d'image fournis sous forme d'une succession de bits qui traduisent en un premier code les états respectifs des pixels d'une image supposée lue par balayage linéaire.

Les bits regroupés en octets du premier code sont convertis en un code compressé permettant une mémorisation d'image sous forme numérique dans un volume réduit d'une mémoire d'une station de micro-édition. Les octets de premier code sont transcodés sous forme de modules de quatre types différents qui permettent respectivement un codage compressif des octets des plages uniformes d'image, des zones de transition, des zones identiques de lignes successives, ainsi que des octets successifs hétérogènes et identiques de répétition de motifs, notamment pour les zones nuancées.

**FIG.3**

| MODULE | PREMIER OCTET D'EN-TETE | | | | | | | | CORRESPONDANCE |
|---|---|---|---|---|---|---|---|---|---|
| | 7 | 6 | 5 | 4 | 3 | 2 | 1 | 0 | |
| M1 | 0 | 1 | 0 | X | X | X | X | X | Plage monochrome à 0 codée sur 1 octet d'en-tête |
| M1 | 0 | 1 | 1 | X | X | X | X | X | Plage monochrome à 1 codée sur 1 octet d'en-tête |
| M1 | 1 | 1 | 0 | X | X | X | X | X | Plage monochrome à 0 codée sur 2 octets d'en-tête |
| M1 | 1 | 1 | 1 | X | X | X | X | X | Plage monochrome à 1 codée sur 2 octets d'en-tête |
| M2 | 0 | 0 | 1 | X | X | X | X | X | Plage codée en clair à 1 octet d'en-tête |
| M2 | 1 | 0 | 1 | X | X | X | X | X | Plage codée en clair à 2 octets d'en-tête |
| M3 | 0 | 0 | 0 | 0 | X | X | X | X | Plage codée en bidimensionnel sur 1 octet d'en-tête |
| M3 | 1 | 0 | 0 | 0 | X | X | X | X | Plage codée en bidimensionnel sur 2 octets d'en-tête |
| M4 | 0 | 0 | 0 | 1 | X | X | X | X | Répétition d'octet codée avec 1 octet d'en-tête |
| M4 | 1 | 0 | 0 | 1 | X | X | X | X | Répétition d'octet codée avec 2 octets d'en-tête |

EP 0 343 584 A1

## Procédé de transcodage de données numériques d'image "bitmap"

L'invention concerne un procédé de transcodage de données numériques pour image "bitmap", notamment pour système informatique destiné à restituer à la demande des images de documents qui ont été préalablement mémorisées sous forme de données numériques.

L'accroissement rapide des possibilités offertes par les ordinateurs individuels permet la vulgarisation de techniques antérieurement réservées aux seuls spécialistes en particulier dans le domaine de l'édition. Il est ainsi possible de reproduire à l'aide d'imprimantes à faisceau laser ou autres des images préalablement mises en mémoire sous forme numérique par un ordinateur, équipé d'un analyseur graphique de document.

Les utilisateurs de tels systèmes peuvent ainsi produire eux-mêmes, avec l'assistance de logiciels spécialisés couramment commercialisés, des documents de bonne qualité associant des reproductions d'images et des textes préalablement mémorisés. Mais la mémorisation de données d'image provenant d'un analyseur graphique de document implique de grandes capacités de mémoire au niveau de l'ordinateur, par exemple de l'ordre d'un mégaoctet par page au format normalisé A4 lue par l'analyseur graphique, à la résolution 300 ppi.

On cherche donc à transcoder les données d'image bitmap fournies sous forme binaire par les analyseurs graphiques de document pour réduire le volume d'informations à mémoriser, tout en permettant une restitution intégrale des images après mémorisation.

On connaît déjà des codes, tel le code HUFFMAN, qui permettent, de compresser notablement le volume de données binaires nécessaire à une mémorisation d'images à partir d'un codage, dit en clair, effectué par un analyseur graphique et considérant chaque image sous forme bitmap, c'est-à-dire uniquement comme un ensemble de points élémentaires.

Les données transcodées dans un but de mémorisation doivent ultérieurement être transcodées en sens inverse au moment de leur exploitation à des fins de reproduction et ceci exige des temps de décodage qui sont souvent longs avec les codes évoqués ci-dessus, en l'absence de moyens matériels auxiliaires spécifiques.

L'invention propose donc un procédé de transcodage de signaux numériques d'image bitmap qui soit compressif et qui permette par sa structure de récupérer rapidement le codage initial, en clair, en partant d'un fichier de mémoire contenant les données compactées des images mémorisées.

Le procédé selon l'invention est destiné à assurer un transcodage compressif des données numériques d'image bitmap qui sont fournies sour forme d'une succession de bits et qui traduisent en un premier code, souvent dit initial ou en clair, les états respectifs des pixels successifs d'au moins une image supposée lue par balayage linéaire.

Selon une caractéristique de l'invention, les bits qui correspondent dans le premier code, aux pixels successifs d'image, sont transcodés, octet par octet et en succession, en un code compressé.

- Les bits qui correspondent dans le premier code aux pixels successifs d'image sont transcodés, octet par octet et en succession, en modules d'un code compressé comprenant chacun un descripteur de plage éventuellement suivi d'octets de premier code maintenus inchangés. Chaque descripteur de plage est composé d'un ou de deux octets précisant la nature de la plage codée et la longueur de cette plage par deux groupes distincts de bits. Les plages de premier code, qui sont composées d'octets successifs identiques eux-mêmes constitués de bits identiques et qui correspondent à des plages monochromes de l'image, sont transcodées sous forme de modules d'un premier type composés d'un descripteur de plage.

Les plages de premier code composées d'au moins un octet comportant des bits correspondants à au moins deux pixels différents dans une succession d'octets non répétitifs, sont transcodées sous forme de modules d'un second type composés d'un descripteur de plage suivi du ou des octets de premier code inchangés.

Les plages du premier code, dont les octets constitutifs sont identiques et en même position de ligne que leurs correspondants d'une ligne de balayage précédente sont transcodées sous forme de modules d'un troisième type composés d'un descripteurs de plage.

Les plages du premier code dont les octets successifs sont de composition hérérogène identique sont transcodées sous forme de modules d'un quatrième type composés d'un descripteur de plage suivi de l'octet de premier code supportant la répétition.

Selon une première variante, les octets successifs identiques des bits correspondant à des pixels successifs identiques sont transcodés sous forme de modules de code compressé d'un premier type. Chaque module du premier type, établi généralement à partir d'au moins deux octets successifs identiques, est composé d'un descripteur de plage comportant au moins un premier octet où au moins deux positions de bits ayant chacune un rang déterminé traduisent respectivement l'identité d'état des pixels concernés et cet état, au moins une partie des autres positions de bits de ce module y précisant en fonction de leur valeur et leur rang d'une part le nombre d'octets du descripteur de plage du module, d'autre part le nombre d'octets successifs de premier code que ce module concerne. Les octets de premier code qui comportent individuellement des bits correspondant à au moins deux pixels différents, sont transcodés sous forme de modules de code compressé d'un second type. Chaque module du second type est composé d'un descripteur de plage d'au moins un octet et d'un octet suivant, le premier d'entre eux comporte deux positions de bits traduisant respectivement l'existence de pixels différents parmi les pixels concernés et le maintien du premier code pour au moins ledit octet suivant. Au moins une partie des autres positions de bits du descripteur de plage de ce module du second type y précise, en fonction des valeurs et des rangs de bits d'une part le nombre d'octets du descripteur de plage du module d'autre part le nombre d'octets successifs en premier code que le module comporte.

L'invention, ses caractéristiques et ses avantages sont précisés dans la description qui suit en liaison avec les figures répertoriées ci-dessous :

- La figure 1 présente le schéma de principe d'une station de micro-édition classique.

- Les figures 2A et 2B présentent deux structures de descripteur de plage pour module de code compressé.

- La figure 3 présente un tableau récapitulatif des structures des modules d'un exemple de code compressé.

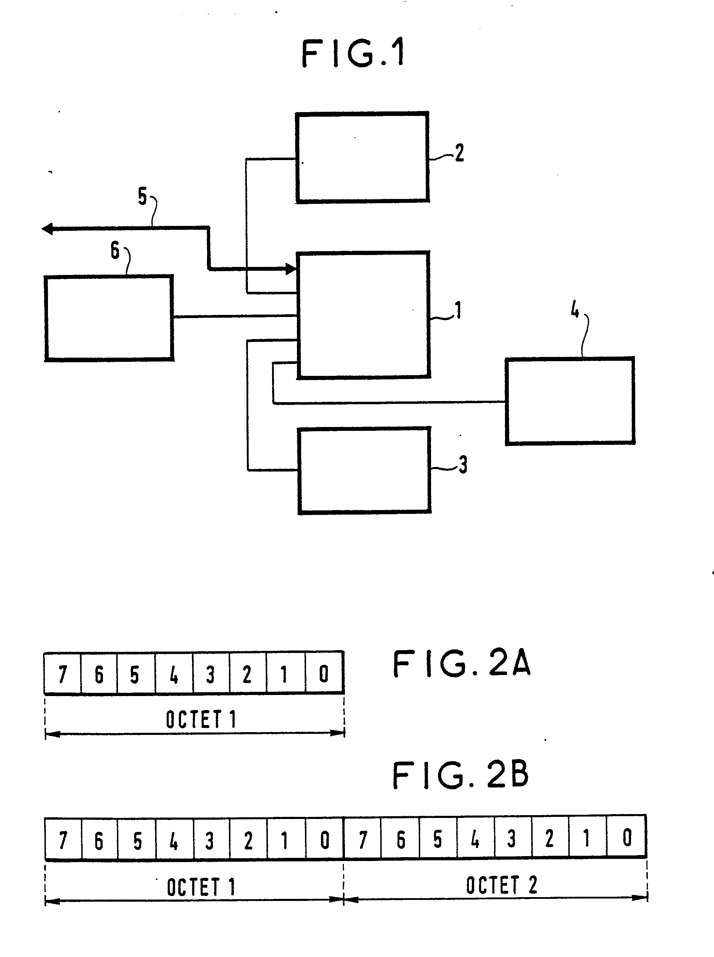

La station de micro-édition présentée à la figure 1 est destinée à la fabrication de documents imprimés, avec l'aide de techniques dites de publication assistée par ordinateur qui impliquent la mise en mémoire sous forme numérique des textes et images à imprimer.

A cet effet, une telle station de micro-édition est organisée autour d'au moins un ordinateur 1, par exemple de type individuel, classiquement doté de mémoires mortes et vives non représentées, d'un écran de visualisation 2 et d'un clavier alphanumérique 3, éventuellement associé à une souris non représentée. Les textes et images à imprimer sont préalablement enregistrés en mémoire d'ordinateur 1 sous forme numérique, en vue d'être organisés selon les désirs de l'utilisateur avec l'assistance de logiciels appropriés et de permettre leur impression par l'intermédiaire d'une imprimante 4, par exemple de type laser, connectée à un port de l'ordinateur 1 à cet effet.

Les textes sont classiquement introduits sous forme numérique en mémoire d'ordinateur, par l'intermédiaire d'équipements annexes dont est doté l'ordinateur. Ces équipements sont par exemple le clavier 3, en lecteur, non figuré, de disques ou disquettes sur lesquels les données de texte et d'image ont été préalablement enregistrées, un modem, non figuré, permettant de recevoir les données numériques transmises par une liaison de télécommunication 5 aboutissant par exemple à un serveur, un analyseur graphique de document ou scanner 6. Un tel analyseur graphique 6 assure la conversion de l'image portée par une face d'un document en une succession de bits représentatifs des pixels d'image, l'image étant supposée lue par balayage linaire. Les bits représentatifs des pixels successifs sur les lignes successives d'image, sont classiquement regroupés en un succession d'octets en vue de leur prise en compte. Un à huit bits, suivant le premier codage choisi, sont donc fournis par l'analyseur graphique pour chaque pixel. Un seul bit suffit pour coder en clair l'état d'un pixel d'une image monochrome selon deux niveaux. Plusieurs bits affectés à un même pixel permettent d'obtenir des nuances de coloration de cette même image, des tramages ou encore différents niveaux de gris dans la reproduction d'une image en noir et blanc. De manière connue, la succession d'octets obtenus pour une image est mémorisée dans un fichier permettant d'accéder aux données binaires d'image à l'aide de logiciels spécialisés de préparation des documents à imprimer, ces logiciels travaillant à partir des textes et/ou des images mémorisées en fichier.

Comme indiqué plus haut, l'un des objectifs du procédé selon l'invention est de transcoder les signaux binaires de premier code, fournis par exemple par un analyseur graphique pour une image traitée selon la technique bitmap, en un code comprimé qui permet de réduire en conséquence le volume de mémoire nécessaire à leur conservation, tout en autorisant une restitution rapide du code initial sans perte d'information, grâce à la brièveté du temps d'accès mémoire nécessaire à leur reconstitution lors de l'exploitation.

A cet effet un processeur assure la prise en compte de chaque octet du premier code, ce processeur est ordinairement situé soit au niveau de l'analyseur graphique 6, soit au niveau de l'ordinateur 1. Chaque octet de premier code est alors considéré en vue de son transcodage soit seul, soit préférablement en combinaison avec les octets successifs voisins afin de former un module de code compressé qui est composé lui aussi d'octets. Ce choix de format facilite le traitement des données binaires d'image bitmap par le ou les processeurs, car il n'implique pas de translation à l'intérieur des registres d'un processeur, ni de manipulation d'index, en conséquence il n'y a pas de pertes de temps correspondantes.

Selon l'invention on transcode les octets successifs de premier code, d'une ou de plusieurs images successives, en modules de code compressé, ces modules sont composés chacun d'un nombre entier d'octets ordinairement beaucoup plus faible que le nombre d'octets de premier code.

Chaque fichier d'image bitmap créé pour mémoriser en code compressé des données numériques fournies en premier code, comporte un entête de définition et suivi des données de l'image.

Cet en-tête de fichier précise de manière connue, des données caractéristiques de prise en compte d'image et de codage. Dans le cas présent y figurent notamment le nombre de lignes d'image, le nombre d'octets par ligne d'image en premier code, le nombre de pixels valides par ligne, une indication relative au codage utilisé exprimée implicitement ou explicitement, une indication éventuelle d'utilisation d'une matrice de DITHER pour la saisie, et dans ce cas les dimensions de cette matrice et en particulier le nombre de lignes concernées d'image.

Chaque module de code compressé comporte aussi un descripteur de plage qui est composé d'un ou deux octets, ceux-ci sont éventuellement suivis par un nombre d'octets qui est alors défini dans le descripteur du module.

Quatre types de modules de code compressé M1, M2, M3 et M4 sont éventuellement mis en oeuvre dans le procédé de transcodage selon l'invention.

Le premier module M1 de code compressé est destiné au transcodage des octets successifs identiques de bits de premier code qui correspondent à des pixels successifs identiques c'est-à-dire à ceux qui appartiennent à une ou plusieurs lignes d'une plage d'image uniforme.

Le second module M2 de code compressé est destiné au transcodage des octets de premier code qui correspondent soit chacun à au moins deux pixels différents, soit isolément à un octet de pixels identiques intercalé entre des octets de pixels différents.

Le troisième module M3 de code compressé est destiné on transcodage des octets de premier code d'une ligne de balayage qui sont identiques et en même position de ligne que leurs correspondants d'une ligne de balayage précédente.

Le quatrième module M4 de code compressé est destiné au transcodage des octets successifs de premier code qui sont de composition hétérogène identique et qui correspondent à une répétition d'un court motif, en particulier dans le cas d'un codage de couleurs ou de nuances de gris nécessitant l'utilisation de plusieurs bits par pixel, ou encore dans le cas de tramage. Chaque pixel est alors représenté par plusieurs bits, classiquement de deux à huit par plan de couleur. Chaque pixel disposant alors de bits de définition dans les différents plans.

Le premier octet du descripteur de chacun des modules de code compressé évoqués ci-dessus contient suivant les cas trois ou quatre positions de bit de rangs déterminés dont les contenus précisent le type du module et le nombre d'octets de son descripteur.

Dans l'exemple d'octet du descripteur de module présenté en figure 2A, la position de bit de rang 7 permet suivant son contenu, c'est-à-dire son état binaire, de préciser si le descripteur qui la comporte s'étend sur un ou deux octets.

La position de bit de rang 6 permet suivant son contenu de préciser si le module qui la comporte est du premier type M1 ou non, c'est-à-dire si le module se rapporte à une plage de pixels identiques ou non.

Les contenus des positions de bit de rangs 5 et 6, qui sont indépendants, précisent soit l'état des pixels identiques du module de type M1 qui les comportent par une première combinaison, soit l'appartenance des deux positions de rang 5 et 6 à un module de type M2 par une seconde combinaison ou encore à un module de l'un des types M3 ou M4 par une troisième combinaison.

Le contenu de la position de bit de rang 4 permet de différencier les modules de type M3 et M4 lorsque les contenus des positions de bit de rangs 5 et 6 correspondent à la troisième combinaison évoquée ci-dessus. Les positions de bit de rang 3, 2, 1 et 0, c'est-à-dire ici de droite, d'un octet de descripteur d'un module et la position de rang 4 d'un octet de descripteur de premier ou second module M1, M2 permettent de définir le nombre d'octets de premier code qui sont transcodés par ce module de code compressé.

Dans le cas d'un descripteur d'un module de code compressé composé de deux octets (figure 2B), le second octet est exploité pour augmenter la capacité de transcodage en nombre d'octets de premier code du module qui le comporte. Les huit positions de bit du second octet de descripteur viennent alors s'additionner aux positions réservées à cet effect dans le premier octet de descripteur considéré.

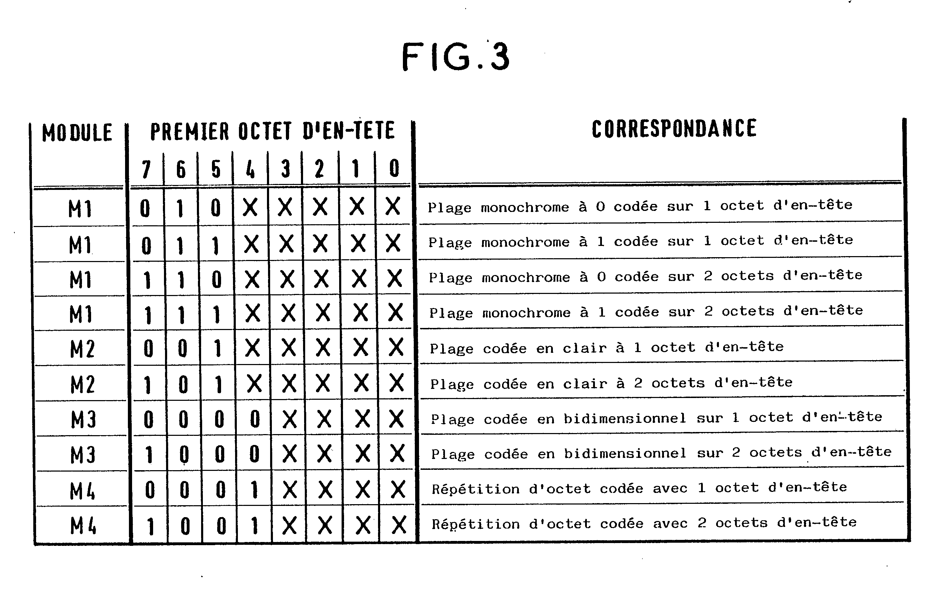

La figure 3 présente un exemple de réalisation de code intermédiaire adapté au transcodage selon l'invention et permet de préciser la manière dont un tel code peut être mis en oeuvre par un processeur, par exemple celui de l'ordinateur 1 de la figure 1.

L'analyseur graphique 6 fournit par exemple une succession d'octets d'image bitmap codée en clair au fur et à mesure de l'analyse d'une image traduite par exemple en monochrome par deux niveaux et donc à raison d'un bit par pixel. Un entête de fichier d'image est classiquement créé par l'utilisateur avant que le fichier ne reçoive une suite de modules de code compressé obtenu par traitement des octets successifs du code en clair par le processeur évoqué plus haut.

Si par exemple la succession d'octets d'image bitmap reçus de l'analyseur correspond à une suite d'un nombre "n" d'octets homogènes et identiques, c'est-à-dire composés de bits de même valeur, qui correspondent à une plage uniforme de pixels, le processeur évoqué plus haut produit un descripteur de plage de module M1. Ce descripteur apparait après un comptage des octets identiques soit jusqu'au premier octet hétérogène, c'est-à-dire doté d'au moins deux bits différents, soit jusqu'à un nombre limite "n" déterminé d'octets.

Ce nombre "n" d'octets est par exemple celui qui est susceptible d'être codé sur treize bits et correspond donc à plus de huit mille octets du code en clair.

Le module M1 comporte un seul octet si le nombre d'octets homogènes et identiques est susceptible d'être codé en cinq bits, cet octet unique est son octet de descripteur.

Dans l'exemple proposé, l'octet de descripteur précise qu'il constitue à lui seul un module M1, par son bit de rang 7 à l'état zéro, qu'il correspond à un groupe d'octets homogènes et identiques du code en clair, par son bit de rang 6 à l'état un et quel est l'état binaire, zéro ou un, commun aux pixels. par son bit de rang 5. Les cinq autres bits de cet unique octet déterminent le nombre d'octets concernés du code en clair, c'est-à-dire l'étendue de la plage uniforme concernée de l'image monochrome envisagée ci-dessus.

L'homme de métier sait aisément reconstituer le code initial à partir d'un tel octet de module M1 à l'aide d'un processeur dûment programmé d'une manière classique qui ne sera pas décrite ici, étant sans rapport immédiat avec l'objet de la présente invention.

Un descripteur de plage de deux octets est constitué, si le nombre "n" d'octets homogène, identiques, successifs nécessite plus de cinq bits pour son codage binaire. Le premier de ces deux octets se différencie du premier octet évoqué ci-dessus par l'état de son bit de rang 7, ici à un, qui précise que le module M1 est composé de deux octets successifs et que treize des bits de ce module du premier type sont exploités pour traduire le nombre d'octets de code en clair qui sont ainsi transcodés.

Il n'y a pas non plus de difficulté pour l'homme de métier à retraduire en code en clair un tel module de code compressé à l'aide d'un processeur.

L'apparition d'un octet hétérogène de code en clair après une suite d'octets homogènes identiques, ou l'apparition d'un octet homogène dont les bits ont une valeur inverse de celles des bits de l'octet précédent, ou encore le comptage du nombre "n" limite d'octets homogènes identiques et successifs déclenche la production d'un module M1 du premier type par le processeur chargé du transcodage.

Dans le cas où la plage de pixels uniformes n'a pu être codée par un seul module M1 il est entrepris de produire un second module M1 dans les mêmes conditions. Il en est de même, en cas d'apparitions successives d'octets homogènes identiques de code en clair qui ont des bits de valeur opposée à ceux des octets précédents.

Il y a production d'un module d'un second type M2, en cas d'apparition d'un octet hétérogène de code en clair dont les bits correspondent à au moins deux pixels d'états différents.

Dans l'exemple proposé en liaison avec la figure 3 un module M2 comporte un descripteur composé d'un ou de deux octets. Le premier octet d'en-tête précise par son bit de rang 7 à l'état zéro ou un, si le module qui le comporte possède un ou deux octets de descripteur. La combinaison des contenus zéro et un des positions de bit de rangs 6 et 5 indique qu'il y a une transition d'état dans un octet de code en clair et qu'au moins cet octet de code en clair est reproduit à l'identique en code intermédiaire, suite au descripteur considéré.

Les cinq autres positions de l'octet d'un descripteur ou les treize autres positions des deux octets successifs d'un descripteur d'un module M2 précisent le nombre d'octets successifs de code en clair, c'est-à-dire reproduits à l'identique, suite au descripteur, en un ou deux octets du module M2 considéré.

Il n'y a pas là non plus de difficulté pour l'homme de métier à revenir au code en clair à partir d'un module M2.

Dans une variante de réalisation également montrée sur la figure 3, il est prévu de coder spécifiquement les suites d'octets qui correspondent à des configurations identiques sur des lignes successives de balayage d'image. Ceci implique une mémorisation temporaire des données d'au moins deux lignes successives d'image.

Cette solution est également mise en oeuvre lorsque l'image a été saisie à l'aide d'une matrice de DITHER et que l'on a répétition de la même configuration de lignes d'image avec un modulo correspondant au nombre de lignes de la matrice prise en compte.

L'identification des configurations d'octets de premier code d'une ligne d'image qui sont identiques et en mêmes positions en ligne que leurs correspondantes d'une ligne précédente d'image, conduit à la production d'un troisième type de module M3 de code compressé.

L'identification des lignes s'obtient aisément par exemple par comptage d'un nombre déterminé d'octets de premier code ou par une détermination correspondante à partir des indications de nombre d'octets contenues dans les modules de code compressé.

Cette identification peut également s'obtenir par insertion d'un codage spécifique, par exemple un code de fin de ligne composé de deux octets dont les bits sont de valeur zéro, lors du transcodage en code compressé.

Dans l'exemple proposé en liaison avec la figure 3, une identité entre lignes ou portions de ligne successives est transcodée par l'intermédiaire d'un module M3. Un tel module M3 comporte un descripteur de plage sur un ou deux octets successifs.

Comme précédemment, le premier octet de descripteur de plage précise, par son bit 7 le nombre d'octets du descripteur qui le comporte, et par une combinaison spécifique de ses bits de rangs 6, 5 et 4, ici tous à zéro, que le codage est bidimensionnel et reproduit au moins partiellement celui d'une ligne précédente d'image.

Les quatre autres positions de bits d'un octet de descripteur, ou les douze autres positions de bits de deux octets successifs de descripteur précisent le nombre d'octets successifs de premier code d'une ligne d'image qui sont concernés.

Dans une autre variante de réalisation elle aussi présentée sur la figure 3, il est prévu de coder spécifiquement les octets successifs du premier code qui ont des compositions hétérogènes identiques.

Ceci s'applique notamment lors de l'emploi d'un nombre "p" de bits pour coder un pixel, "p" étant supérieur à un lorsque des nuances sont prévues au niveau des images.

L'analyseur graphique fournit alors un premier code dans lequel chaque pixel est codé par un groupe de "p" bits, une même configuration des "p" bits étant utilisée pour les pixels identiques.

Des pixels successifs et identiques se traduisent alors par une succession d'octets hétérogènes et identiques en premier code et l'identification d'une telle succession conduit à la génération d'un quatrième type de module M4 en code compressé.

Un tel module M4 comporte un descripteur de plage composé d'un ou de deux octets successifs.

Comme les précédents, le premier octet de descripteur précise le nombre d'octets du descripteur qui le comporte, au moyen de son bit de rang 7 ; il définit également par une combinaison spécifique de ses bits de rangs 6, 5 et 4, ici respectivement à zéro, zéro et un, qu'il y a répétivité d'octets hétérogènes.

Les quatre autres positions de bit de l'octet du descripteur ou les treize autres positions de bit des deux octets successifs du descripteur précisent le nombre d'octets successifs de premier code qui sont concernés par cette répétition. L'octet hétérogène de premier code qui est à répéter est alors reproduit à l'identique, suite au descripteur du module M4 considéré.

Une nouvelle fois la reconstitution du premier code à partir d'un tel module de code compressé et à l'aide d'un processeur, est aisée à l'aide de programmes simples dont la divulgation est sans rapport immédiat avec l'invention.

Les différents modules M1, M2, M3, M4 susceptibles de coexister dans une même fichier d'image voire une même ligne d'image permettent de retrouver le nombre et la constitution des octets de premier code d'une image tout en permettant la mémorisation de cette image sous un faible volume.

Le code compressé selon l'invention offre l'avantage de ne pas être expansif puisqu'il implique au plus un octet ou un mot de deux octets en supplément par ligne dans le cas le plus défavorable où tous les octets de premier code d'une ligne subsisteraient en premier code après transcodage en code compressé.

**Revendications**

1/ Procédé de transcodage de données numériques d'image "bitmap" fournis sous forme d'une succession de bits qui traduisent en un premier code, les états respectifs des pixels successifs d'au moins une image supposée lue par balayage linéaire, caractérisé en ce que les bits qui correspondent dans le premier code aux pixels successifs d'image, sont transcodés octet par octet et en succession en un code compressé dans lequel en premier lieu les octets successifs identiques de bits correspondant à des pixels successifs identiques sont transcodés sous forme de modules de code compressé d'un premier type (M1), chaque module du premier type, établi à partir d'au moins deux octets successifs correspondant à des pixels identiques, étant composé d'un descripteur de plage comportant au moins un premier octet où au moins deux positions de bits ayant chacune un rang déterminé (6,5) traduisent respectivement l'identité d'état des pixels concernés et cet état, au moins une partie des autres positions de bits de ce descripteur de plage y précisant en fonction de leurs rangs et de leurs contenus d'une part le nombre d'octets du descripteur, d'autre part le nombre d'octets successifs de premier code qu'il concerne, et dans lequel en second lieu les octets de premier code qui comportent individuellement des bits correspondant à au moins deux pixels d'états différents sont transcodés sous forme de modules de code compressé d'un second type (M2), chaque module du second type étant composé d'un descripteur de plage comportant au moins un octet et d'au moins un octet suivant dont le premier comporte deux positions de bits traduisant respectivement l'existence de pixels différents parmi les pixels concernés et le maintien du premier code pour au moins le dit octet suivant, au moins une partie des autres positions de bits du descripteur de ce module du second type y précisant en fonction de leurs rangs et de leurs contenus d'une part le nombre d'octets du descripteur considéré, d'autre part le nombre d'octets successifs, de premier code que le module comporte en succession, lesdits octets successifs laissés en premier code incorporant éventuellement un octet de pixels identiques entre deux octets relatifs à des pixels dont les états diffèrent.

2/ Procédé de transcodage selon la revendication 1, caractérisé en ce que les octets de premier code d'une ligne qui sont identiques et en même position en ligne que leurs correspondants d'une ligne précédente de l'image sont transcodés sous forme de modules de code compressé d'un troisième type (M3), chaque module du troisième type étant composé d'un descripteur de plage comportant au moins un octet qui comporte lui-même trois positions de bits (4, 5, 6) de rangs déterminés traduisant l'existence d'une telle identité entre lignes successives d'image, les autres positions de bits du descripteur de ce module du troisième type précisant en fonction de leurs contenus et de leurs rangs d'une part le nombre d'octets de ce descripteur, d'autre part le nombre d'octets successifs de premier code qui sont concernés.

3/ Procédé de transcodage selon la revendication 1, à partir d'un premier code dans lequel chaque pixel est défini par un groupe de bits dont le nombre est un sous-multiple de huit, caractérisé en ce que les octets de premier code, qui sont successifs et de composition hétérogène identique, sont transcodés sous forme de modules de code compressé d'un quatrième type (M4), chaque module du quatrième type étant composé d'un descripteur de plage comportant au moins un octet d'en-tête qui comporte lui-même trois positions de bits de rang déterminés traduisant l'existence d'une répétitivité concernant des octets successifs de code en clair, les autres positions de bits de l'en-tête de ce module du quatrième type précisant en fonction de leur contenus et de leurs rangs, d'une part le nombre d'octets de ce descripteur, d'autre part le nombre d'octets successifs de premier code qui sont concernés.

4/ Procédé de transcodage selon au moins l'une des revendications 1, 2 et 3 caractérisé en ce que le premier octet de descripteur de plage de chacun des différents modules de code compressé comporte une même première position réservée de bit (7) dont le contenu définit le nombre d'octets de l'en-tête qui le comprend, et une même seconde position réservée de bit (6) qui traduit, suivant son contenu, l'homogénéité ou l'hétérogénéité des octets de premier code que transcode le module de code compressé qui la comprend.

5/ Procédé de transcodage selon la revendication 4 caractérisé en ce que le premier octet du descripteur de plage de chacun des modules de code compressé comporte une troisième position réservée de bit (5) dont le contenu combiné avec celui de la seconde position réservée (6) du même descripteur respectivement différencie les premiers modules de code compressé, des seconds et ces premiers et seconds modules de l'ensemble formé par les troisièmes et quatrièmes modules, ladite troisième position réservée du premier octet de descripteur d'un premier module traduisant de plus l'état des pixels que transcode ce premier module.

6/ Procédé de transcodage selon la revendication 5, caractérisé en ce que le premier octet de descripteur de plage des troisièmes et quatrièmes modules de code intermédiaire, comporte une quatrième position réservée de bit (4) dont le contenu précise le type du module qui le comporte.

7/ Procédé de transcodage selon les revendications 1 et 2 pour premier code dans lequel chaque pixel est représenté par un seul bit caractérisé en ce que le premier octet de descripteur de plage de chacun des modules de code compressé comporte une même première position réservée de bit (7) dont le contenu défini le nombre d'octets du descripteur qui la comprend, une même seconde position réservée de bit qui traduit selon son contenu l'homogénéité ou l'hétérogénéité des octets de premier code que transcode le module de code compressé qui la comprend, et une même troisième position réservée, dont le contenu combiné à celui de la second position réservée du même en-tête respectivement différencie les premiers, seconds et troisièmes modules entre eux, chaque troisième position réservée d'un premier module traduisant de plus l'état des pixels que transcode ce premier module.

8/ Procédé de transcodage de signaux numériques d'image monochrome fournis sous forme de modules en code compressé composés d'octets organisés selon au moins l'une des revendications précédentes caractérisé en ce que les dits modules sont transcodés en une succession de bits représentatifs de pixels d'image en premier code par conversion selon le procédé inverse de celui préconisé par au moins l'une des revendications considérées.

# FIG.1

# FIG.2A

| 7 | 6 | 5 | 4 | 3 | 2 | 1 | 0 |
|---|---|---|---|---|---|---|---|

OCTET 1

# FIG.2B

| 7 | 6 | 5 | 4 | 3 | 2 | 1 | 0 | 7 | 6 | 5 | 4 | 3 | 2 | 1 | 0 |
|---|---|---|---|---|---|---|---|---|---|---|---|---|---|---|---|

OCTET 1          OCTET 2

# FIG.3

| MODULE | PREMIER OCTET D'EN-TETE | | | | | | | | CORRESPONDANCE |
|---|---|---|---|---|---|---|---|---|---|
| | 7 | 6 | 5 | 4 | 3 | 2 | 1 | 0 | |
| M1 | 0 | 1 | 0 | X | X | X | X | X | Plage monochrome à 0 codée sur 1 octet d'en-tête |
| M1 | 0 | 1 | 1 | X | X | X | X | X | Plage monochrome à 1 codée sur 1 octet d'en-tête |
| M1 | 1 | 1 | 0 | X | X | X | X | X | Plage monochrome à 0 codée sur 2 octets d'en-tête |
| M1 | 1 | 1 | 1 | X | X | X | X | X | Plage monochrome à 1 codée sur 2 octets d'en-tête |
| M2 | 0 | 0 | 1 | X | X | X | X | X | Plage codée en clair à 1 octet d'en-tête |
| M2 | 1 | 0 | 1 | X | X | X | X | X | Plage codée en clair à 2 octets d'en-tête |
| M3 | 0 | 0 | 0 | 0 | X | X | X | X | Plage codée en bidimensionnel sur 1 octet d'en-tête |
| M3 | 1 | 0 | 0 | 0 | X | X | X | X | Plage codée en bidimensionnel sur 2 octets d'en-tête |
| M4 | 0 | 0 | 0 | 1 | X | X | X | X | Répétition d'octet codée avec 1 octet d'en-tête |
| M4 | 1 | 0 | 0 | 1 | X | X | X | X | Répétition d'octet codée avec 2 octets d'en-tête |

EP 0 343 584 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 483 317 (DE GROAT)<br>* Figure 4; colonne 5, ligne 24 -<br>colonne 6, ligne 28 *<br>--- | 1,3 | H 04 N 1/415<br>H 03 M 7/48 |
| A | US-A-3 950 609 (TANAKA et al.)<br>* Figure 3; colonne 3, ligne 50 -<br>colonne 4, ligne 32 *<br>--- | 1,3 | |
| A | US-A-4 684 923 (KOGA)<br>* Figures 1,2,4; colonne 3, ligne 61 -<br>colonne 7, ligne 54 *<br>--- | 1,3 | |
| A | US-A-3 947 627 (TANAKA)<br>* Figure 8; colonne 5, lignes 18-43 *<br>--- | 1,2 | |
| A | IBM TECHNICAL DISCLOSURE BULLETIN, vol.<br>16, no. 3, August 1973, pages 928-929,<br>New York, US; W.C. COOK et al.: "Data<br>compression for raster display"<br>* Figures 1-3; pages 928-929 *<br>--- | 1,2 | |
| A | US-A-4 327 379 (KADAKIA et al.)<br>----- | 1 | |

**DOMAINES TECHNIQUES RECHERCHES (Int. Cl.4)**

H 04 N
H 03 M

Le présent rapport a été établi pour toutes les revendications

| Lieu de la recherche | Date d'achèvement de la recherche | Examinateur |
|---|---|---|
| LA HAYE | 05-09-1989 | FEUER F.S. |